# EUROPEAN PATENT APPLICATION

(11) **EP 4 112 771 A1**
(43) Date of publication of application: **04.01.2023**
(21) Application number: 22180737.3
(22) Date of filing: 23.06.2022
(51) Int. Cl.: C23C 16/34, C23C 16/44, C23C 16/455, C23C 16/458, C30B 29/00, C23C 16/32, H01L 21/687

(54) **SUSCEPTOR AND MANUFACTURING METHOD THEREOF**

(30) Priority: 24.06.2021 JP 2021105175; 25.04.2022 JP 2022071844
(71) Applicant: Coorstek KK, Tokyo 141-0032 (JP)
(72) Inventor: Kanno, Akira, Yamagata, 999-1351 (JP); Endo, Noriaki, Yamagata, 999-1351 (JP); Tabei, Takahiro, Yamagata, 999-1351 (JP); Inoue, Masatoshi, Yamagata, 999-1351 (JP)
(74) Representative: Grünecker Patent- und Rechtsanwälte PartG mbB

(57) **Abstract**

The present invention relates to a susceptor including a substrate including a carbon material and having one main surface on which a silicon wafer is to be placed, and another main surface facing the one main surface, in which an entire surface of the substrate is covered with a thin film including silicon carbide, the one main surface has an emissivity variation of 3% or less, and a ratio of an average emissivity between the one main surface and the another main surface facing the one main surface is from 1:1 to 1:0.8.

## Description

### TECHNICAL FIELD

The present invention relates to a susceptor and a manufacturing method thereof and, for example, relates to a susceptor for holding a wafer in an epitaxial deposition apparatus and a method for manufacturing the same.

### BACKGROUND ART

In an epitaxial deposition apparatus that is one of semiconductor manufacturing apparatuses, a carbon composite material prepared by covering a carbon material (referred to as carbon substrate) with silicon carbide (SiC) is used as a susceptor that is a member for holding a silicon wafer. The susceptor includes, according to the shape, a pancake type, a barrel type, a sheet type, etc., and depending on the apparatus or processing method, a plurality of types are used.

In the case of manufacturing the susceptor, irrespective of the type, the susceptor is, in the state of a carbon substrate, placed in a predetermined coating furnace, and silicon carbide (SiC) is deposited on a surface of the carbon substrate by CVD method, etc., whereby a susceptor composed of a carbon composite material is obtained.

Meanwhile, at the time of depositing a silicon carbide (SiC) thin film on a surface of the carbon substrate by CVD method, the silicon carbide film is not allowed to deposit in the contact portion between a carbon substrate supporting jig and the carbon substrate.

To cope with such a problem, Patent Literature 1 describes a technique of once taking out the carbon substrate from the furnace after the first deposition treatment, changing the contact position of the carbon substrate with the jig, and then performing the second and subsequent deposition treatments. This enables obtaining a carbon composite material covered, throughout its surface, with silicon carbide (SiC).

A plurality of times of deposition treatments by moving the contact position is an effective technique for eliminating a contact mark with the jig, but once taking out the carbon composite material from the furnace, the carbon composite material is exposed to air outside the furnace, and there is a problem that the silicon carbide film surface may be contaminated. If contaminated, a new silicon carbide film is stacked on the contaminated layer and when the carbon composite material is used as a susceptor, this gives rise to contamination of a silicon wafer in the epitaxial process.

Therefore, in the invention described in Patent Literature 1, after silicon carbide is first deposited, the carbon composite material is once taken out so as to change support position to eliminate the support mark, a purification treatment (blowing of a halogen gas) is performed on the carbon composite material surface to reduce the contamination of the surface, and silicon carbide is again deposited in the furnace.

Patent Literature 1: JP-A-2008-174841 (the term "JP-A" as used herein means an "unexamined published Japanese patent application")

### SUMMARY OF INVENTION

However, in the method disclosed in Patent Literature 1, the carbon substrate is once taken out from the furnace, and thus the possibility of contamination still exists. In addition, since a plurality of times of deposition treatments need to be performed at intervals, there is a problem that the man-hour and cost disadvantageously increase.

Furthermore, in a portion with which a jig for holding the carbon substrate contacts, the silicon carbide film thickness is thinner than other parts and, in the case of two times depositions, is approximately halved. Consequently, in the epitaxial deposition process, carbon of the substrate may be exposed due to wear of the silicon carbide film.

In addition, the thickness non-uniformity of the silicon carbide film also becomes a factor causing a film thickness variation in the epitaxial deposition process for a silicon wafer. In the case where the silicon carbide film thickness greatly varies, there is a problem that the thermal conductivity differs and thus it is difficult to obtain a uniform epitaxial film.

Also, when the silicon carbide film covering the carbon substrate is non-uniform, the emissivity in the temperature range where the susceptor is used varies. When the emissivity greatly varies, temperature irregularity occurs in the susceptor, giving rise to a problem that the wafer temperature varies and this leads to a film thickness variation of the epitaxial film.

The present invention has been made under these circumstances and aims at providing a susceptor including a carbon composite material prepared by covering a surface of a substrate including a carbon material with a silicon carbide (SiC) thin film, which is a contamination-reduced susceptor capable of increasing the uniformity of the film thickness of the silicon carbide film formed on the substrate and thereby suppressing the thermal conductivity variation, and a manufacturing method thereof.

The susceptor according to the present invention invented to solve the above-described problems is a susceptor including a substrate including a carbon material and having one main surface on which a silicon wafer is to be placed, and another main surface facing the one main surface, in which
an entire surface of the substrate is covered with a thin film including silicon carbide,
the one main surface has an emissivity variation of 3% or less, and
a ratio of an average emissivity between the one main surface and the another main surface facing the one main surface is from 1:1 to 1:0.8.

The another main surface facing the one main surface preferably has an emissivity variation of 3% or less.

In addition, it is preferred that a ratio of a film thickness of the thin film formed on the another main surface to a film thickness of the thin film formed on the one main surface is 0.7 or more and 1.2 or less, a film thickness difference between a central part and an outer edge part in the one main surface is 40% or less of an average film thickness value of the thin film formed on the one main surface, and a film thickness difference between the maximum film thickness and the minimum film thickness in the outer edge part of the one main surface is 40% or less of the average film thickness value of the thin film formed on the one main surface.

Furthermore, the film thickness of the thin film including silicon carbide formed on the entire surface of the substrate is preferably at least 60 µm.

According to such a configuration, the uniformity of the thin film formed on a surface of the substrate is enhanced, and the uniformity of thermal conduction in the one main surface is improved. As a result, in the epitaxial deposition process for a silicon wafer using the susceptor, a uniform epitaxial film can be obtained.

Also, the manufacturing method of a susceptor according to the present invention invented to solve the above-described problems is a method of manufacturing the susceptor, the method including:
supporting the substrate including the carbon material in a chamber while moving a support position to the substrate; and
supplying a raw material gas such that a supply direction is parallel to the one main surface of the substrate, thereby forming a thin film including silicon carbide on the entire surface of the substrate.
According to this method, the susceptor above in which contamination is reduced can be obtained.

According to the present invention, a susceptor including a carbon composite material prepared by covering a surface of a substrate including a carbon material with a silicon carbide (SiC) thin film, which is a contamination-reduced susceptor capable of increasing the uniformity of the film thickness of the silicon carbide film formed on the substrate and thereby suppressing the thermal conductivity variation, and a manufacturing method thereof can be provided.

### BRIEF DESCRIPTION OF DRAWINGS

FIG. 1 is a cross-sectional view of the susceptor according to the present invention.
FIG. 2 is a partially enlarged cross-sectional view of the susceptor of FIG. 1.
FIG. 3 is a cross-sectional view schematically illustrating a CVD apparatus used at the time of manufacture of the susceptor of FIG. 1.
FIG. 4 is a plan view of the CVD apparatus of FIG. 3.

### DESCRIPTION OF EMBODIMENTS

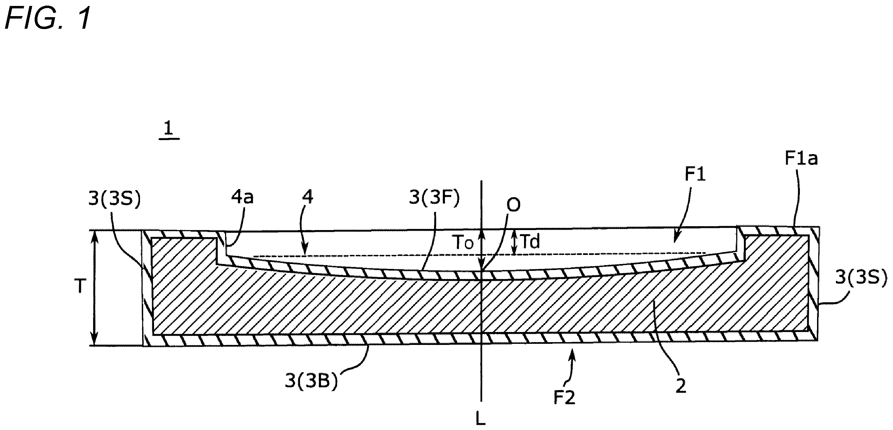

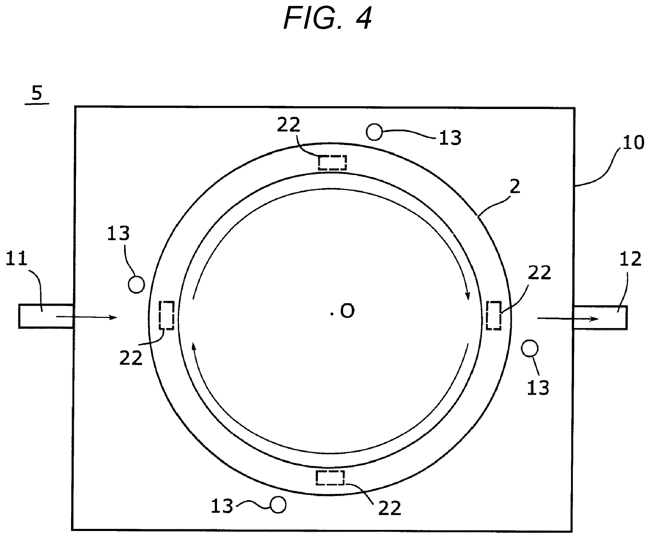

One embodiment of each of the susceptor according to the present invention and the manufacturing method thereof is described below based on FIG. 1 to FIG. 4. The drawings are schematic or conceptual, and the relationship between the thickness and width of each portion, the proportions of sizes among portions, etc. are not accurately illustrated.

As illustrated in FIG. 1, the susceptor 1 includes a disk-shaped carbon substrate 2 composed of a carbon material. The carbon substrate 2 is covered, throughout its surface, with a thin film 3 having a predetermined thickness (for example, 60 µm or more) and being composed of silicon carbide.

That is, the thin film 3 includes a thin film 3F composed of silicon carbide covering one main surface F1 that is a wafer placing surface of the susceptor 1, a thin film 3B composed of silicon carbide covering another main surface F2 that is a back surface facing the one main surface F1, and a thin film 3S composed of silicon carbide covering the outer peripheral surface of the carbon substrate 2.

Also, the susceptor 1 is a so-called sheet-type susceptor in which one recessed counterbored portion 4 for placing a semiconductor substrate is formed in the one main surface F1.

The counterbored portion 4 is formed to have a circular shape in planar view, and a cylindrical concave portion 4a is formed in the center. In addition, the susceptor 1 presents circular symmetry about the axis of rotation L passing through its central part O. Here, denoting as To the depth of the deepest part (central part O) of the counterbored portion 4, the average depth Td is To/2.

The ratio (T/Td) between the thickness T of the susceptor 1 and the average depth Td is preferably 6≤T/Td≤30. The ratio (T/To) between the thickness T of the susceptor 1 and the depth To is preferably 3≤T/To≤13.

As the counterbored portion 4 is formed such that the ratio (T/Td) between the thickness T of the susceptor 1 and the average depth Td satisfies 6≤T/Td≤30, an effect of preventing warpage can thereby be obtained.

If the ratio (T/Td) between the thickness T of the susceptor 1 and the average depth Td is less than 6, the counterbore is too deep relative to the thickness of the susceptor 1, and this may disadvantageously result in poor deposition on the wafer outer periphery. Also, if the ratio (T/Td) between the thickness T of the susceptor 1 and the average depth Td exceeds 30, the susceptor is thick-walled, and the influence of rigidity of the carbon substrate 2 cannot be neglected, undesirably making it difficult to control the warpage amount in a thin film.

As described above, a carbon material applicable as a susceptor for semiconductors is used for the carbon substrate 2, and silicon carbide is used for the thin film 3. The thin film 3 is formed on the entire surface of the carbon substrate 2 and has roles in preventing outward diffusion of dust or impurities from the carbon substrate 2, protecting the entire surface of the carbon substrate 2, and suppressing warpage of the carbon substrate 2.

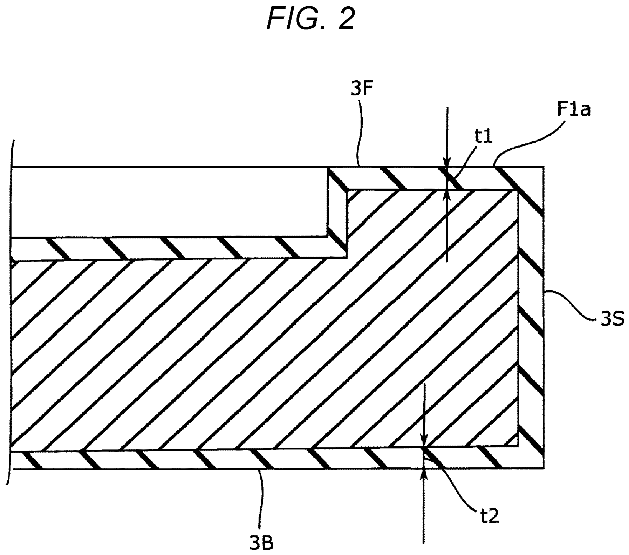

Here, the ratio between the average of the film thickness t1 of the thin film 3F formed on the main surface F1 of the susceptor 1 illustrated in FIG. 2 and the average of the film thickness t2 of the thin film 3B formed on the another main surface F2 is preferably from 0.7 to 1.2.

If the ratio above is smaller than 0.7, a thermal conductivity difference is generated in the epitaxial deposition process using the susceptor, and a uniform epitaxial film may be hardly obtained.

If the ratio is larger than 1.2, in addition to the thermal conductivity difference attributable to thickness variation of the thin film 3, warpage of the susceptor readily occurs, and the epitaxial film disadvantageously becomes non-uniform.

In the main surface F1 of the susceptor 1, the film thickness difference d1 between the central part O and the outer edge part F1a is preferably 40% or less of the average of the film thickness t1 of the thin film 3F formed on the main surface F1.

In addition, in the main surface F1 of the susceptor 1, the film thickness difference d2 between the maximum film thickness and the minimum film thickness in the outer edge part F1a is preferably 40% or less of the average of the film thickness t1 of the thin film 3F formed on the main surface F1.

When the film thickness difference d1 or d2 is 40% or less of the average of the film thickness t1, the uniformity of thermal conduction in the main surface F1 is improved, and in the epitaxial deposition process using the susceptor, a uniform epitaxial film can be obtained.

On the other hand, if the film thickness difference is more than 40% of the average of the film thickness t1, an irregularity is likely to occur, and the thermal conduction in the main surface F1 becomes non-uniform, as a result, a uniform epitaxial film may not be obtained.

The susceptor 1 is formed such that in the temperature range (from 900 to 1,300°C) during the epitaxial deposition process, the emissivity variation on the wafer placing surface (main surface F1) is within 3% and the ratio of average emissivity between the wafer placing surface and its backside surface (another main surface F2) is from 1:1 to 1:0.8.

In addition, the susceptor is preferably formed such that on the backside surface (another main surface F2) of the wafer placing surface as well, the emissivity variation in the same plane is within 3%.

By setting the emissivity of the susceptor 1 in this way, the thermal conductivity variation of the susceptor is suppressed, and temperature irregularity does not occur, so that the temperature of the wafer placed can be made uniform to prevent the film thickness variation of the epitaxial film.

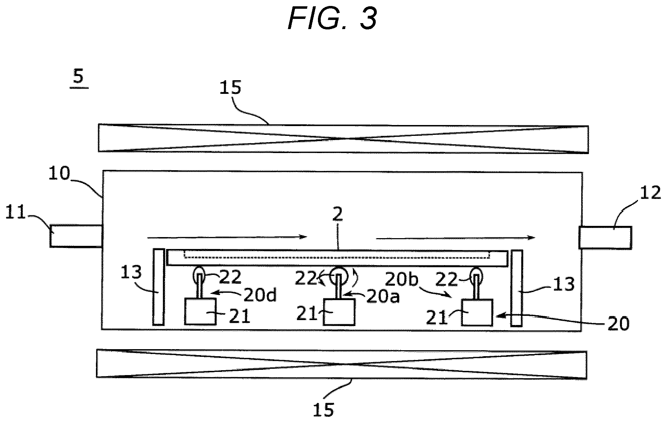

The above-described susceptor 1 can be manufactured using, for example, a CVD apparatus 5 illustrated in FIG. 3.

The CVD apparatus 5 illustrated in FIG. 3 has a chamber 10 for forming a processing space, a gas inflow port 11 provided on the side surface of the chamber 10 for supplying a carrier gas (hydrogen gas) into the chamber 10, and a gas outflow port 12 provided on the opposite-side chamber 10 side surface facing the inflow port 11.

The apparatus further includes, in the chamber 10, a support portion 20 for supporting the underside of the carbon substrate 2 of the susceptor 1 and a plurality of columnar guard members 13 disposed to surround the carbon substrate 2 and slidably support the lateral periphery (outer periphery) of the carbon substrate 2.

The support portion 20 has a plurality of support legs 20a to 20d disposed to let a roller 22 provided to be rotatable at a constant speed by a motor 21 rotate along a circumferential direction of the carbon substrate 2. In FIG. 3, the support leg 20c is not shown as it is behind the support leg 20a. The rollers 22 of the support legs 20a to 20d abut on a peripheral edge portion of the backside surface of the carbon substrate 2 and are configured such that each roller 22 unidirectionally rotates and the carbon substrate 2 is thereby rotated on the central part O while being supported. The rotational movements (start of rotation, stop, direction of rotation, rotational speed) of rollers 22 of respective support legs 20a to 20d are controlled to be synchronized with one another by a control unit (not shown).

In addition, as illustrated in FIG. 3, a heater portion 15 is provided above and below the chamber 10 and thus, the apparatus is configured to enable a temperature rise up to a predetermined temperature in the furnace.

In the case of manufacturing the susceptor 1 by using the CVD apparatus 5, a carbon substrate 2 composed of a carbon material, where a circular counterbored portion is formed in advance, is disposed on the support legs 20a to 20d in the chamber 10.

Subsequently, the rollers 22 of the support legs 20a to 20d are caused to start rotating at a predetermined rotational speed by a control unit (not shown). This allows the carbon substrate 2 to rotate on the central part O at a predetermined speed (for example, 0.1 rpm).

In addition, the temperature inside the chamber 10 is raised, for example, to 500°C by driving the heater portion 15, and the air inside the chamber 10 is sucked from the gas outflow port 12 to make a vacuum state.

Next, a carrier gas (H₂) is introduced at a predetermined flow rate into the chamber 10 from the gas inflow port 11. Thereafter, the temperature inside the chamber 10 is raised, for example, to 1,300°C, and raw material gases (SiCl₄, C₃H₈) are introduced together with the carrier gas for a predetermined time. The raw material gas concentration in the chamber 10 at the start of introduction is, for example, from 15% to 20%.

Here, the raw material gases are caused to flow along the top and bottom surfaces of the carbon substrate 2 by the carrier gas and discharged from the gas outflow port 12.

Also, since the carbon substrate 2 is rotated on the central portion O by a plurality of rotationally driven rollers 22 provided to support the bottom surface-side peripheral edge portion of the carbon substrate 2, the support position in the bottom surface-side peripheral edge portion of the carbon substrate 2 is not located at the same place (not fixed but changes), and the film thickness uniformity of the film formed is enhanced.

Raw material gases are supplied into the chamber 10 for a predetermined time (for example, 14 hours) so that the film formed can have a predetermined thickness (for example, 60 µm or more).

Then, the raw material gases are stepwise diluted to a concentration of 1/2 to 1/4 of the normal concentration at a final stage of the raw material gas supply process (for example, a stage of 5 to 60 minutes before the end of the process).

Consequently, the raw material gases turn into more dilute raw material gases than usual, leading to a lower deposition rate than usual, and are deposited in the state of crystal grains being uniform in size. As a result, the deposition amount in plane is likely to be uniform, and the emissivity in the same plane can be made more constant. Specifically, the emissivity variation on the wafer placing surface (and its back side) is adjusted to be within 3%, and the ratio of average emissivity between the wafer placing surface and its backside surface is adjusted to be from 1:1 to 1:0.8.

When a pre-set raw material gas supply time has elapsed, the supply of raw material gases is stopped and after the further elapse of a predetermined time (for example, after 1 hour), the rotation of rollers 22 is stopped.

Through such processing, a thin film 3 composed of silicon carbide is formed on the carbon substrate 2 and in turn, the susceptor 1 of the present invention is manufactured. During exposure of the carbon substrate 2 to raw material gases, the positions supporting the carbon substrate 2 in the chamber 10 are always changed, and therefore, the thin film 3 is formed with high film thickness uniformity. More specifically, the susceptor 1 is formed such that the ratio between the average of the film thickness t1 of the thin film 3F formed on the main surface F1 and the average of the film thickness t2 of the thin film 3B formed on the another main surface F2 is preferably from 0.7 to 1.2. In addition, the susceptor 1 is formed such that in the main surface F1, the film thickness difference d1 between the central part O and the outer edge part F1a and the film thickness difference d2 between the maximum film thickness and the minimum film thickness in the outer edge part F1a are preferably 40% or less of the average of the film thickness t1 of the thin film 3F formed on the main surface F1.

As described above, according to the embodiments of the present invention, in the susceptor 1, the thin film 3 formed on the carbon substrate 2 is formed with high film thickness uniformity, so that the emissivity variation on the wafer placing surface can be within 3% and the ratio of average emissivity between the wafer placing surface and its backside surface can be from 1:1 to 1:0.8.

In addition, the susceptor 1 is preferably formed such that the ratio between the average of the film thickness t1 of the thin film 3F formed on the main surface F1 and the average of the film thickness t2 of the thin film 3B formed on the another main surface F2 is from 0.7 to 1.2, and the susceptor 1 is formed such that in the main surface F1, the film thickness difference d1 between the central part O and the outer edge part F1a or the film thickness difference d2 between the maximum film thickness and the minimum film thickness in the outer edge part F1a is 40% or less of the average of the film thickness t1 of the thin film 3F formed on the main surface F1.

When these are satisfied, the uniformity of the thin film 3 formed on a surface of the carbon substrate 2 is enhanced, and the uniformity of thermal conduction in the main surface F1 is improved without occurrence of temperature irregularity in the susceptor 1.

As a result, a uniform epitaxial film can be obtained on a silicon wafer in the epitaxial deposition process using the susceptor.

Furthermore, at the time of forming the thin film composed of silicon carbide on the carbon substrate 2 composed of a carbon material by CVD, the support positions with respect to the carbon substrate 2 are not fixed, so that a uniform thin film can be formed on the entire carbon substrate 2. Consequently, unlike a usual case, the carbon substrate 2 need not be taken out from the chamber halfway through the thin film formation, and a single-layer thin film with reduced contamination can be formed.

In the embodiment above, as the method for suppressing the emissivity variation in the same plane of the wafer placing surface (and backside surface), raw material gases are diluted at a final stage of the raw material gas supply process, but the present invention is not limited to this example.

Also, in the embodiment above, a susceptor where a counterbored portion is formed is described as an example, but the present invention is not limited to this embodiment and can be applied also to a susceptor having no counterbored portion.

In addition, in the case of having a counterbored portion, the portion is not limited to the cylindrical counterbored portion illustrated, and the present invention can be applied to a susceptor having, for example, a concavely curved counterbored portion.

The susceptor according to the present invention and its manufacturing method are further descried based on Examples.

### [Experiment 1]

In Experiment 1, isotropic graphite was used as the material of the substrate of the susceptor, and a plurality of carbon substrates in which a counterbore is formed were prepared. Using the CVD apparatus illustrated in FIG. 3, a silicon carbide film was formed on a substrate surface under a plurality of film thickness-forming conditions.

In the CVD apparatus, the carbon substrate was placed in the chamber and after vacuuming, the temperature in the chamber was raised up to 500°C, followed by introduction of a carrier gas (H₂) into the chamber. Subsequently, the temperature in the chamber was raised up to 1,300°C and while rotating the carbon substrate at a rotational speed of 0.1 rpm with care of not fixing the substrate support positions, raw material gases (SiCl₄, C₃H₈) were supplied along the top and bottom surfaces of the carbon substrate. After the elapse of a predetermined time (14 hours), the supply of raw material gases was stopped and after 1 hour, the rotation of the carbon substrate was stopped, thereby forming a 70 µm-thick silicon carbide thin film on the substrate surface.

Here, out of the raw material gas supply process (14 hours), at a final stage (0.2 hours before the end of the process), the raw material gases were diluted by diluting the concentrations so as to suppress the emissivity variation on the wafer placing surface and its backside surface of the susceptor formed.

The emissivity variation was set as the conditions of Examples 1 to 4 and Comparative Examples 1 to 3, and the emissivity variation was adjusted by the raw material gas concentrations. Note that the emissivity measurement on the wafer placing surface and its backside surface was performed by a method using FTIR (Fourier transform infrared spectroscopy) manufactured by Thermo Fisher Scientific K.K. and an integrating sphere, at four positions in total, namely, center of the wafer placing surface of the carbon substrate and three positions located, at 120° interval, on the concentric circle having radius of 50 % of the wafer placing surface outward from the center. The average emissivity was an average of the four measurement values. The emissivity variation was calculated based on the four measurement values by a formula of ((maximum value) - (minimum value)) / (average value). As for the backside surface of the wafer placing surface, the measurement and calculation were performed with the same measurement positions as the wafer placing surface.

In Example 1, the emissivity variation on the wafer placing surface of the carbon substrate was 1%, the emissivity variation on the backside surface of the wafer placing surface was 1%, and the ratio of the average emissivity between the wafer placing surface and the backside surface was 1:1.

In Example 2, the emissivity variation on the wafer placing surface of the carbon substrate was 2%, the emissivity variation on the backside surface of the wafer placing surface was 1%, and the ratio of the average emissivity between the wafer placing surface and the backside surface was 1:0.9.

In Example 3, the emissivity variation on the wafer placing surface of the carbon substrate was 3%, the emissivity variation on the backside surface of the wafer placing surface was 1%, and the ratio of the average emissivity between the wafer placing surface and the backside surface was 1:0.8.

In Example 4, the emissivity variation on the wafer placing surface of the carbon substrate was 1%, the emissivity variation on the backside surface of the wafer placing surface was 3%, and the ratio of the average emissivity between the wafer placing surface and the backside surface was 1:0.8.

In Example 5, the emissivity variation on the wafer placing surface of the carbon substrate was 2%, the emissivity variation on the backside surface of the wafer placing surface was 4%, and the ratio of the average emissivity between the wafer placing surface and the backside surface was 1:0.8.

In Comparative Example 1, the emissivity variation on the wafer placing surface of the carbon substrate was 4%, the emissivity variation on the backside surface of the wafer placing surface was 3%, and the ratio of the average emissivity between the wafer placing surface and the backside surface was 1:0.9.

In Comparative Example 2, the emissivity variation on the wafer placing surface of the carbon substrate was 3%, the emissivity variation on the backside surface of the wafer placing surface was 3%, and the ratio of the average emissivity between the wafer placing surface and the backside surface was 1:0.7.

A processing of forming an epitaxial film on a silicon wafer was performed using the susceptors manufactured in Examples 1 to 5 and Comparative Examples 1 and 2.

The results of Experiment 1 are shown in Table 1. The evaluation under respective conditions shown in Table 1 was performed using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 1**

| Film Thickness 70 µm | Example 1 | Example 2 | Example 3 | Example 4 | Example 5 | Comparative Example 1 | Comparative Example 2 |
|---|---|---|---|---|---|---|---|
| Emissivity variation on front surface (%) | 1 | 2 | 3 | 1 | 2 | 4 | 3 |
| Emissivity variation on back surface (%) | 1 | 1 | 1 | 3 | 4 | 3 | 3 |
| Ratio of emissivity between front and back surfaces | 1:1 | 1:0.9 | 1:0.8 | 1:0.8 | 1:0.8 | 1:0.9 | 1:0.7 |
| Evaluation | A | A | A | A | B | C | C |

It was confirmed from the results of Experiment 1 that in the case of forming a 70 µm-thick silicon carbide thin film on a substrate surface, when the emissivity variation on the wafer placing surface (front surface) is within 3% and the ratio of the average emissivity between the wafer placing surface and its backside surface is from 1:1 to 1:0.8, the uniformity of the epitaxial film formed on the silicon wafer is improved.

### [Experiment 2]

In Experiment 2, evaluation was performed using the same conditions as in Experiment 1 except that the thickness of the silicon carbide thin film on the substrate surface was changed to 30 µm.

In Example 6, the emissivity variation on the wafer placing surface of the carbon substrate was 1%, the emissivity variation on the backside surface of the wafer placing surface was 1%, and the ratio of the average emissivity between the wafer placing surface and the backside surface was 1:1.

In Example 7, the emissivity variation on the wafer placing surface of the carbon substrate was 2%, the emissivity variation on the backside surface of the wafer placing surface was 1%, and the ratio of the average emissivity between the wafer placing surface and the backside surface was 1:0.9.

In Example 8, the emissivity variation on the wafer placing surface of the carbon substrate was 3%, the emissivity variation on the backside surface of the wafer placing surface was 1%, and the ratio of the average emissivity between the wafer placing surface and the backside surface was 1:0.8.

In Example 9, the emissivity variation on the wafer placing surface of the carbon substrate was 1%, the emissivity variation on the backside surface of the wafer placing surface was 3%, and the ratio of the average emissivity between the wafer placing surface and the backside surface was 1:0.8.

In Example 10, the emissivity variation on the wafer placing surface of the carbon substrate was 2%, the emissivity variation on the backside surface of the wafer placing surface was 4%, and the ratio of the average emissivity between the wafer placing surface and the backside surface was 1:0.8.

In Comparative Example 3, the emissivity variation on the wafer placing surface of the carbon substrate was 4%, the emissivity variation on the backside surface of the wafer placing surface was 3%, and the ratio of the average emissivity between the wafer placing surface and the backside surface was 1:0.9.

In Comparative Example 4, the emissivity variation on the wafer placing surface of the carbon substrate was 3%, the emissivity variation on the backside surface of the wafer placing surface was 3%, and the ratio of the average emissivity between the wafer placing surface and the backside surface was 1:0.7.

A processing of forming an epitaxial film on a silicon wafer was performed using the susceptors manufactured in Examples 6 to 10 and Comparative Examples 3 and 4.

The results of Experiment 2 are shown in Table 2. The evaluation under respective conditions shown in Table 2 was performed using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 2**

| Film Thickness 30 µm | Example 6 | Example 7 | Example 8 | Example 9 | Example 10 | Comparative Example 3 | Comparative Example 4 |
|---|---|---|---|---|---|---|---|
| Emissivity variation on front surface (%) | 1 | 2 | 3 | 1 | 2 | 4 | 3 |
| Emissivity variation on back surface (%) | 1 | 1 | 1 | 3 | 4 | 3 | 3 |
| Ratio of emissivity between front and back surfaces | 1:1 | 1:0.9 | 1:0.8 | 1:0.8 | 1:0.8 | 1:0.9 | 1:0.7 |
| Evaluation | A | A | A | A | B | C | C |

It was confirmed from the results of Experiment 2 shown in Table 2 that in the case of forming a 30 µm-thick silicon carbide thin film on a substrate surface, when the emissivity variation on the wafer placing surface (front surface) is within 3% and the ratio of the average emissivity between the wafer placing surface and its back side surface is from 1:1 to 1:0.8, the uniformity of the epitaxial film formed on the silicon wafer is improved.

### [Experiment 3]

In Experiment 3, evaluation was performed using the same conditions as in Experiment 1 except that the thickness of the silicon carbide thin film on the substrate surface was changed to 60 µm.

In Example 11, the emissivity variation on the wafer placing surface of the carbon substrate was 1%, the emissivity variation on the backside surface of the wafer placing surface was 1%, and the ratio of the average emissivity between the wafer placing surface and the backside surface was 1:1.

In Example 12, the emissivity variation on the wafer placing surface of the carbon substrate was 2%, the emissivity variation on the backside surface of the wafer placing surface was 1%, and the ratio of the average emissivity between the wafer placing surface and the backside surface was 1:0.9.

In Example 13, the emissivity variation on the wafer placing surface of the carbon substrate was 3%, the emissivity variation on the backside surface of the wafer placing surface was 1%, and the ratio of the average emissivity between the wafer placing surface and the backside surface was 1:0.8.

In Example 14, the emissivity variation on the wafer placing surface of the carbon substrate was 1%, the emissivity variation on the backside surface of the wafer placing surface was 3%, and the ratio of the average emissivity between the wafer placing surface and the backside surface was 1:0.8.

In Example 15, the emissivity variation on the wafer placing surface of the carbon substrate was 2%, the emissivity variation on the backside surface of the wafer placing surface was 4%, and the ratio of the average emissivity between the wafer placing surface and the backside surface was 1:0.8.

In Comparative Example 5, the emissivity variation on the wafer placing surface of the carbon substrate was 4%, the emissivity variation on the backside surface of the wafer placing surface was 3%, and the ratio of the average emissivity between the wafer placing surface and the backside surface was 1:0.9.

In Comparative Example 6, the emissivity variation on the wafer placing surface of the carbon substrate was 3%, the emissivity variation on the backside surface of the wafer placing surface was 3%, and the ratio of the average emissivity between the wafer placing surface and the backside surface was 1:0.7.

A processing of forming an epitaxial film on a silicon wafer was performed using the susceptors manufactured in Examples 11 to 15 and Comparative Examples 5 and 6.

The results of Experiment 3 are shown in Table 3. The evaluation under respective conditions shown in Table 3 was performed using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 3**

| Film Thickness 60 µm | Example 11 | Example 12 | Example 13 | Example 14 | Example 15 | Comparative Example 5 | Comparative Example 6 |
|---|---|---|---|---|---|---|---|
| Emissivity variation on front surface (%) | 1 | 2 | 3 | 1 | 2 | 4 | 3 |
| Emissivity variation on back surface (%) | 1 | 1 | 1 | 3 | 4 | 3 | 3 |
| Ratio of emissivity between front and back surfaces | 1:1 | 1:0.9 | 1:0.8 | 1:0.8 | 1:0.8 | 1:0.9 | 1:0.7 |
| Evaluation | A | A | A | A | B | C | C |

It was confirmed from the results of Experiment 3 shown in Table 3 that in the case of forming a 60 µm-thick silicon carbide thin film on a substrate surface, when the emissivity variation on the wafer placing surface (front surface) is within 3% and the ratio of the average emissivity between the wafer placing surface and its backside surface is from 1:1 to 1:0.8, the uniformity of the epitaxial film formed on the silicon wafer is improved.

### [Experiment 4]

In Experiment 4, evaluation was performed using the same conditions as in Experiment 1 except that the thickness of the silicon carbide thin film on the substrate surface was changed to 140 µm.

In Example 16, the emissivity variation on the wafer placing surface of the carbon substrate was 1%, the emissivity variation on the backside surface of the wafer placing surface was 1%, and the ratio of the average emissivity between the wafer placing surface and the backside surface was 1:1.

In Example 17, the emissivity variation on the wafer placing surface of the carbon substrate was 2%, the emissivity variation on the backside surface of the wafer placing surface was 1%, and the ratio of the average emissivity between the wafer placing surface and the backside surface was 1:0.9.

In Example 18, the emissivity variation on the wafer placing surface of the carbon substrate was 3%, the emissivity variation on the backside surface of the wafer placing surface was 1%, and the ratio of the average emissivity between the wafer placing surface and the backside surface was 1:0.8.

In Example 19, the emissivity variation on the wafer placing surface of the carbon substrate was 1%, the emissivity variation on the backside surface of the wafer placing surface was 3%, and the ratio of the average emissivity between the wafer placing surface and the backside surface was 1:0.8.

In Example 20, the emissivity variation on the wafer placing surface of the carbon substrate was 2%, the emissivity variation on the backside surface of the wafer placing surface was 4%, and the ratio of the average emissivity between the wafer placing surface and the backside surface was 1:0.8.

In Comparative Example 7, the emissivity variation on the wafer placing surface of the carbon substrate was 4%, the emissivity variation on the backside surface of the wafer placing surface was 3%, and the ratio of the average emissivity between the wafer placing surface and the backside surface was 1:0.9.

In Comparative Example 8, the emissivity variation on the wafer placing surface of the carbon substrate was 3%, the emissivity variation on the backside surface of the wafer placing surface was 3%, and the ratio of the average emissivity between the wafer placing surface and the backside surface was 1:0.7.

A processing of forming an epitaxial film on a silicon wafer was performed using the susceptors manufactured in Examples 16 to 20 and Comparative Examples 7 and 8.

The results of Experiment 4 are shown in Table 4. The evaluation under respective conditions shown in Table 4 was performed using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 4**

| Film Thickness 140 µm | Example 16 | Example 17 | Example 18 | Example 19 | Example 20 | Comparative Example 7 | Comparative Example 8 |
|---|---|---|---|---|---|---|---|
| Emissivity variation on front surface (%) | 1 | 2 | 3 | 1 | 2 | 4 | 3 |
| Emissivity variation on back surface (%) | 1 | 1 | 1 | 3 | 4 | 3 | 3 |
| Ratio of emissivity between front and back surfaces | 1:1 | 1:0.9 | 1:0.8 | 1:0.8 | 1:0.8 | 1:0.9 | 1:0.7 |
| Evaluation | A | A | A | A | B | C | C |

It was confirmed from the results of Experiment 4 shown in Table 4 that in the case of forming a 140 µm-thick silicon carbide thin film on a substrate surface, when the emissivity variation on the wafer placing surface (front surface) is within 3% and the ratio of the average emissivity between the wafer placing surface and its backside surface is from 1:1 to 1:0.8, the uniformity of the epitaxial film formed on the silicon wafer is improved.

### [Experiment 5]

In Experiment 5, evaluation was performed using the same conditions as in Experiment 1 except that the thickness of the silicon carbide thin film on the substrate surface was changed to 200 µm.

In Example 21, the emissivity variation on the wafer placing surface of the carbon substrate was 1%, the emissivity variation on the backside surface of the wafer placing surface was 1%, and the ratio of the average emissivity between the wafer placing surface and the backside surface was 1:1.

In Example 22, the emissivity variation on the wafer placing surface of the carbon substrate was 2%, the emissivity variation on the backside surface of the wafer placing surface was 1%, and the ratio of the average emissivity between the wafer placing surface and the backside surface was 1:0.9.

In Example 23, the emissivity variation on the wafer placing surface of the carbon substrate was 3%, the emissivity variation on the backside surface of the wafer placing surface was 1%, and the ratio of the average emissivity between the wafer placing surface and the backside surface was 1:0.8.

In Example 24, the emissivity variation on the wafer placing surface of the carbon substrate was 1%, the emissivity variation on the backside surface of the wafer placing surface was 3%, and the ratio of the average emissivity between the wafer placing surface and the backside surface was 1:0.8.

In Example 25, the emissivity variation on the wafer placing surface of the carbon substrate was 2%, the emissivity variation on the backside surface of the wafer placing surface was 4%, and the ratio of the average emissivity between the wafer placing surface and the backside surface was 1:0.8.

In Comparative Example 9, the emissivity variation on the wafer placing surface of the carbon substrate was 4%, the emissivity variation on the backside surface of the wafer placing surface was 3%, and the ratio of the average emissivity between the wafer placing surface and the backside surface was 1:0.9.

In Comparative Example 10, the emissivity variation on the wafer placing surface of the carbon substrate was 3%, the emissivity variation on the backside surface of the wafer placing surface was 3%, and the ratio of the average emissivity between the wafer placing surface and the backside surface was 1:0.7.

A processing of forming an epitaxial film on a silicon wafer was performed using the susceptors manufactured in Examples 21 to 25 and Comparative Examples 9 and 10.

The results of Experiment 5 are shown in Table 5. The evaluation under respective conditions shown in Table 5 was performed using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 5**

| Film Thickness 200 µm | Example 21 | Example 22 | Example 23 | Example 24 | Example 25 | Comparative Example 9 | Comparative Example 10 |
|---|---|---|---|---|---|---|---|
| Emissivity variation on front surface (%) | 1 | 2 | 3 | 1 | 2 | 4 | 3 |
| Emissivity variation on back surface (%) | 1 | 1 | 1 | 3 | 4 | 3 | 3 |
| Ratio of emissivity between front and back surfaces | 1:1 | 1:0.9 | 1:0.8 | 1:0.8 | 1:0.8 | 1:0.9 | 1:0.7 |
| Evaluation | A | A | A | A | B | C | C |

It was confirmed from the results of Experiment 5 shown in Table 5 that in the case of forming a 200 µm-thick silicon carbide thin film on a substrate surface, when the emissivity variation on the wafer placing surface (front surface) is within 3% and the ratio of the average emissivity between the wafer placing surface and its backside surface is from 1:1 to 1:0.8, the uniformity of the epitaxial film formed on the silicon wafer is improved.

From these results of Experiments 1 to 5, it was confirmed that under all conditions of the thickness of the silicon carbide thin film formed on a substrate surface, when the emissivity variation on the wafer placing surface (front surface) is within 3% and the ratio of the average emissivity between the wafer placing surface and its backside surface is from 1:1 to 1:0.8, the uniformity of the epitaxial film formed on the silicon wafer is improved.

It is also confirmed that, more preferably, when the emissivity variation on the susceptor back surface is within 3%, the uniformity of the epitaxial film formed on the silicon wafer is better improved.

### [Experiment 6]

In Experiment 6, a suitable film thickness of the silicon carbide film formed on a surface of a carbon substrate was examined. In Examples 26 to 33, the film thickness was adjusted by the raw material gas supply time. Furthermore, in Experiment 6, the raw material gases were diluted at a final stage of the raw material gas supply process to adjust the emissivity variation on both the wafer placing surface and the backside surface of the susceptor obtained to fall within 3% and the ratio of the average emissivity between the wafer placing surface and its backside surface to fall in the range of 1:1 to 1:0.8.

Then, an epitaxial deposition processing and a cleaning treatment were repeatedly performed using the susceptor obtained so as to verify whether or not a predetermined life time (continuous operation 4,000 hours) can be achieved.

In Example 26, the film thickness of the silicon carbide film on the main surface (wafer placing surface) was 42 µm. Also, the film thickness was 55 µm in Example 27, 58 µm in Example 28, 61 µm in Example 29, and 66 µm in Example 30.

In addition, the film thickness was 70 µm in Example 31, 80 µm in Example 32, and 100 µm in Example 33.

The results of Experiment 6 are shown in Table 6.

**Table 6**

| | Example 26 | Example 27 | Example 28 | Example 29 | Example 30 | Example 31 | Example 32 | Example 33 |
|---|---|---|---|---|---|---|---|---|
| Film thickness (µm) | 42 | 55 | 58 | 61 | 66 | 70 | 80 | 100 |
| Results | Not achieved | Not achieved | Not achieved | Achieved | Achieved | Achieved | Achieved | Achieved |

As shown in Table 6, the susceptors where the thickness of the silicon carbide film is less than 60 µm could not achieve a required life. Accordingly, it was confirmed that the thickness of the silicon carbide film is preferably 60 µm or more.

### [Experiment 7]

In Experiment 7, isotropic graphite was used as the material of the substrate of the susceptor, and a carbon substrate where a counterbored portion is formed was prepared. Using the CVD apparatus illustrated in FIG. 3, a silicon carbide film was formed on a substrate surface under a plurality of film thickness-forming conditions.

Subsequently, a processing of forming an epitaxial film on a silicon wafer was performed using the susceptors formed under respective conditions.

In the manufacture of the susceptor, at the time of forming a silicon carbide film on a substrate surface of the susceptor by using the CVD apparatus illustrated in FIG. 3, the film thickness was adjusted by increasing or decreasing the processing time. Furthermore, in Experiment 7, the raw material gases were diluted at a final stage of the raw material gas supply process to adjust the emissivity variation on both the wafer placing surface and backside surface of the susceptor obtained to fall within 3% and the ratio of the average emissivity between the wafer placing surface and its backside surface to fall in the range of 1:1 to 1:0.8.

After the formation of the susceptor, the ratio of the average of the film thickness of the silicon carbide film formed on another main surface (wafer non-placing surface) to the average of the film thickness of the silicon carbide film formed on the main surface (wafer placing surface) was determined. The average values of the film thickness of the silicon carbide film formed on the main surface (wafer placing surface) and the film thickness of the silicon carbide film formed on the another main surface (wafer non-placing surface) were determined by performing measurement at cross sections of positions same as the emissivity measurement positions by optical microscope and calculating average of the measured values.

As shown in Table 7, the ratio is 0.5 in Example 34, 0.6 in Example 35, 0.7 in Example 36, 0.8 in Example 37, 0.9 in Example 38, and 1.0 in Example 39.

Also, the ratio is 1.1 in Example 40, 1.2 in Example 41, 1.3 in Example 42, and 1.4 in Example 43.

In all of Examples 34 to 43, in the main surface (wafer placing surface) of the susceptor, the proportion (%) of the film thickness difference between the center and the outer edge part to the average of the film thickness of the thin film formed on the main surface was 30%. Furthermore, in all susceptors, in the main surface (wafer placing surface) of the susceptor, the proportion (%) of the film thickness difference between the maximum film thickness and minimum film thickness in the outer edge part to the average of the film thickness of the thin film formed on the main surface was 30%.

The results of Experiment 7 are shown in Table 7. The evaluation under respective conditions shown in Table 7 was performed using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 7**

| | Film Thickness Ratio | Evaluation |
|---|---|---|
| Example 34 | 0.5 | B |
| Example 35 | 0.6 | B |
| Example 36 | 0.7 | A |
| Example 37 | 0.8 | A |
| Example 38 | 0.9 | A |
| Example 39 | 1.0 | A |
| Example 40 | 1.1 | A |
| Example 41 | 1.2 | A |
| Example 42 | 1.3 | B |
| Example 43 | 1.4 | B |

It was confirmed from the results of Experiment 7 that when the ratio of the average of the film thickness of the silicon carbide film formed on another main surface (wafer non-placing surface) to the average of the film thickness of the silicon carbide film formed on the main surface (wafer placing surface) of the susceptor is from 0.7 to 1.2, the film thickness uniformity of the epitaxial film is improved.

### [Experiment 8]

In Experiment 8, as with Experiment 7, using the CVD apparatus illustrated in FIG. 3, a silicon carbide film was formed on a substrate surface under a plurality of film thickness-forming conditions.

Subsequently, a processing of forming an epitaxial film on a silicon wafer was performed using the susceptors formed under respective conditions.

In the manufacture of the susceptor, at the time of forming a silicon carbide film on a substrate surface of the susceptor by using the CVD apparatus illustrated in FIG. 3, the film thickness was adjusted by increasing or decreasing the processing time. Furthermore, the raw material gases were diluted at a final stage of the raw material gas supply process to adjust the emissivity variation on both the wafer placing surface and backside surface of the susceptor obtained to fall within 3% and the ratio of the average emissivity between the wafer placing surface and its backside surface to fall in the range of 1:1 to 1:0.8.

After the formation of the thin film, in the main surface (wafer placing surface) of the susceptor taken out from the CVD apparatus, the proportion (%) of the film thickness difference between the center and the outer edge part to the average of the film thickness of the thin film formed on the main surface was determined.

The proportion was 0% in Example 44, 10% in Example 45, 20% in Example 46, 30% in Example 47, and 40% in Example 48.

Also, the proportion was 50% in Example 49 and 60% in Example 50.

In all of Examples 44 to 50, the ratio of the average of the film thickness of the silicon carbide film formed on another main surface (wafer non-placing surface) to the average of the film thickness of the silicon carbide film formed on the main surface (wafer placing surface) of the susceptor was 1.0. Furthermore, in all susceptors, in the main surface (wafer placing surface) of the susceptor, the proportion (%) of the film thickness difference between the maximum film thickness and minimum film thickness in the outer edge part to the average of the film thickness of the thin film formed on the main surface was 30%.

The results of Experiment 8 are shown in Table 8. The evaluation under respective conditions shown in Table 8 was performed, as with Experiment 7, using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 8**

| | Proportion (%) | Evaluation |
|---|---|---|
| Example 44 | 0 | A |
| Example 45 | 10 | A |
| Example 46 | 20 | A |
| Example 47 | 30 | A |
| Example 48 | 40 | A |
| Example 49 | 50 | B |
| Example 50 | 60 | B |

It was confirmed from the results of Experiment 8 that when in the main surface (wafer placing surface) of the susceptor, the film thickness difference between the center and the outer edge part relative to the average of the film thickness of the thin film formed on the main surface is from 0% to 40%, the film thickness uniformity of the epitaxial film is improved.

### [Experiment 9]

In Experiment 9, as with Experiment 7, using the CVD apparatus illustrated in FIG. 3, a silicon carbide film was formed on a substrate surface under a plurality of film thickness-forming conditions.

Subsequently, a processing of forming an epitaxial film on a silicon wafer was performed using the susceptors formed under respective conditions.

In the manufacture of the susceptor, at the time of forming a silicon carbide film on a substrate surface of the susceptor by using the CVD apparatus illustrated in FIG. 3, the film thickness was adjusted by increasing or decreasing the processing time. Furthermore, the raw material gases were diluted at a final stage of the raw material gas supply process to adjust the emissivity variation on both the wafer placing surface and backside surface of the susceptor obtained to fall within 3% and the ratio of the average emissivity between the wafer placing surface and its backside surface to fall in the range of 1:1 to 1:0.8.

After the formation of the thin film, in the main surface (wafer placing surface) of the susceptor taken out from the CVD apparatus, the proportion (%) of the film thickness difference between the maximum film thickness and minimum film thickness in the outer edge part to the average of the film thickness of the thin film formed on the main surface was determined.

The proportion was 0% in Example 51, 10% in Example 52, 20% in Example 53, 30% in Example 54, and 40% in Example 55.

Also, the proportion was 50% in Example 56, and 60% in Example 57.

In all of Examples 51 to 57, the ratio of the average of the film thickness of the silicon carbide film formed on another main surface (wafer non-placing surface) to the average of the film thickness of the silicon carbide film formed on the main surface (wafer placing surface) of the susceptor was 1.0. Furthermore, in all susceptors, in the main surface (wafer placing surface) of the susceptor, the proportion (%) of the film thickness difference between the center and the outer edge part to the average of the film thickness of the thin film formed on the main surface was 30%.

The results of Experiment 9 are shown in Table 9. The evaluation under respective conditions shown in Table 9 was performed, as with Experiments 7 and 8, using the uniformity of the epitaxial film formed on the silicon wafer. The uniformity was rated as A when the in-plane distribution of the film thickness of the epitaxial film was ±5% or less, rated as B when more than ±5% to ±7%, and rated as C when more than ±7%.

**Table 9**

| | Proportion (%) | Evaluation |
|---|---|---|
| Example 51 | 0 | A |
| Example 52 | 10 | A |
| Example 53 | 20 | A |
| Example 54 | 30 | A |
| Example 55 | 40 | A |
| Example 56 | 50 | B |
| Example 57 | 60 | B |

It was confirmed from the results of Experiment 9 that when in the main surface (wafer placing surface) of the susceptor, the film thickness difference between the maximum film thickness and minimum film thickness in the outer edge part relative to the average of the film thickness of the thin film formed on the main surface is from 0% to 40%, the film thickness uniformity of the epitaxial film is improved.

Although the present invention has been described in detail and by reference to the specific embodiments, it is apparent to one skilled in the art that various modifications or changes can be made without departing the spirit and scope of the present invention. This application is based on Japanese Patent Application (No. 2021-105175) filed on June 24, 2021 and Japanese Patent Application (No. 2022-071844) filed on April 25, 2022, the disclosure of which is incorporated herein by reference.
- 1: Susceptor
- 2: Carbon substrate
- 3: Thin film
- 4: Counterbored portion
- 5: CVD apparatus
- 10: Chamber
- 11: Gas inflow port
- 12: Gas outflow port
- 20: Support portion

## Claims

1. A susceptor comprising a substrate comprising a carbon material and having one main surface on which a silicon wafer is to be placed, and another main surface facing the one main surface, wherein
an entire surface of the substrate is covered with a thin film comprising silicon carbide,
the one main surface has an emissivity variation of 3% or less, and
a ratio of an average emissivity between the one main surface and the another main surface facing the one main surface is from 1:1 to 1:0.8.

2. The susceptor according to claim 1, wherein the another main surface facing the one main surface has an emissivity variation of 3% or less.

3. The susceptor according to claim 1 or 2, wherein a ratio of a film thickness of the thin film formed on the another main surface to a film thickness of the thin film formed on the one main surface is 0.7 or more and 1.2 or less, a film thickness difference between a central part and an outer edge part in the one main surface is 40% or less of an average film thickness value of the thin film formed on the one main surface, and a film thickness difference between the maximum film thickness and the minimum film thickness in the outer edge part of the one main surface is 40% or less of the average film thickness value of the thin film formed on the one main surface.

4. The susceptor according to any one of claims 1 to 3, wherein the film thickness of the thin film comprising silicon carbide formed on the entire surface of the substrate is at least 60 µm.

5. A method of manufacturing the susceptor according to any one of claims 1 to 4, the method comprising:
supporting the substrate comprising the carbon material in a chamber while moving a support position to the substrate; and
supplying a raw material gas such that a supply direction is parallel to the one main surface of the substrate, thereby forming a thin film comprising silicon carbide on the entire surface of the substrate.
